# FASCICULE DE BREVET EUROPEEN

(11) **EP 0 702 862 B1**
(45) Date de publication et mention de la délivrance du brevet: **08.10.1997**
(21) Numéro de dépôt: 94918405.5
(22) Date de dépôt: 03.06.1994
(51) Int. Cl.: H03L 7/085

(54) **PROCEDE D'AMELIORATION DE L'IMMUNITE AU BRUIT D'UNE BOUCLE A VERROUILLAGE DE PHASE ET DISPOSITIF METTANT EN OEUVRE CE PROCEDE**
VERFAHREN ZUR VERBESSERUNG DER RAUSCHUNEMPFINDLICHKEIT EINES PHASENREGELKREISES UND EINRICHTUNG, DIE EIN SOLCHES VERFAHREN VERWENDET
PROCESS FOR ENHANCING THE NOISE IMMUNITY OF A PHASE-LOCKED LOOP AND DEVICE FOR APPLYING SAME.

(30) Priorité: 08.06.1993 FR 9306836
(43) Date de publication de la demande: 27.03.1996
(73) Titulaire: THOMSON multimedia, 92400 Courbevoie (FR)
(72) Inventeur: DELMAS, Christian, F-92402 Courbevoie Cédex (FR); PAILLARDET, Frédéric, F-92402 Courbevoie Cédex (FR); DELL'OVA, Francis, F-92402 Courbevoie Cédex (FR)
(74) Mandataire: Ruellan-Lemonnier, Brigitte
(86) Numéro de dépôt international: FR9400659
(87) Numéro de publication internationale: WO9429964

(56) Documents cités:
- GB-A- 2 067 372
- US-A- 4 435 657
- US-A- 4 872 155
- US-A- 5 008 629
- US-A- 5 028 885

## Description

L'invention se rapporte à un procédé d'amélioration de l'immunité au bruit d'une boucle à verrouillage de phase utilisée dans le domaine du traitement des signaux de télévision, notamment lors d'un verrouillage sur la fréquence des signaux de synchronisation. L'invention se rapporte également à un dispositif comprenant une boucle à verrouillage de phase et mettant en oeuvre ledit procédé.

L'invention est destinée particulièrement aux boucles à verrouillage de phases réalisées en circuits intégrés, notamment en technologie MOS, plus particulièrement CMOS.

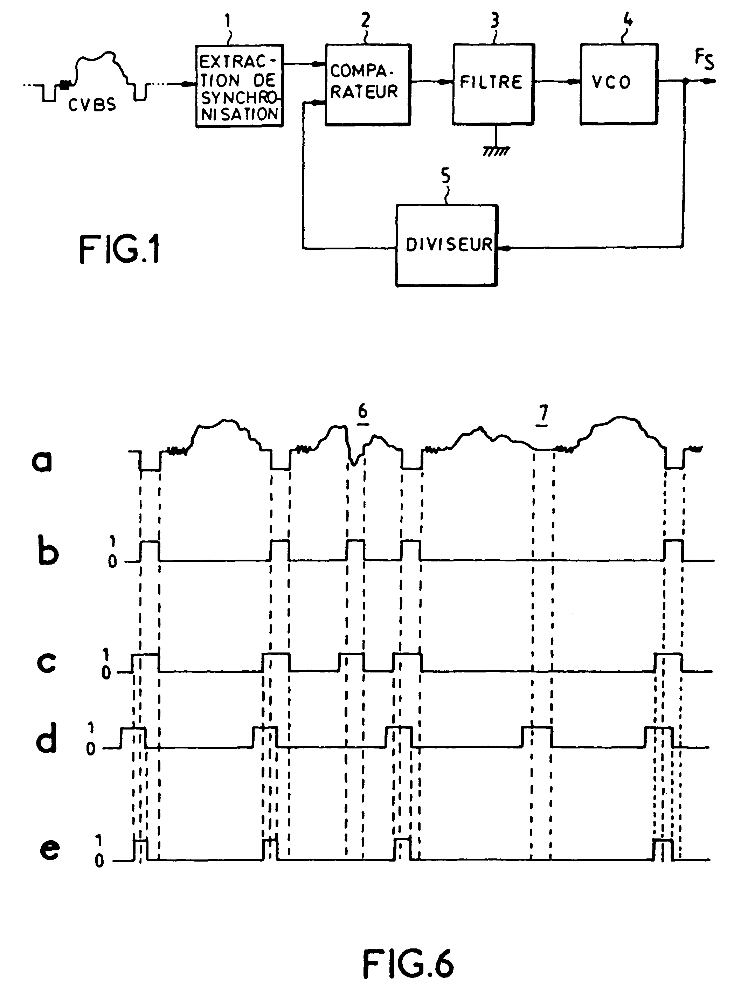

Un diagramme fonctionnel d'une boucle à verrouillage de phase ("Phase Locked Loop" ou PLL) classique est représenté à la figure 1. Selon cet exemple particulier de l'art antérieur, la PLL reçoit un signal de référence constitué par des impulsions de synchronisation élaborées par un extracteur de synchronisation 1 à partir du signal vidéo composite en bande de base ("Composite Video Baseband Signal" ou CVBS).

Un comparateur de phase 2 reçoit sur l'une de ses entrées la synchronisation ainsi extraite. En série avec le comparateur de phase 2, on connecte un filtre 3, ainsi qu'un oscillateur contrôlé en tension 4 ("Voltage Controlled Oscillator" ou VCO). La sortie du VCO est rebouclée sur une autre entrée du comparateur de phase 2. La boucle de retour comporte un diviseur de fréquence par N référencé 5.

Lorsque le dispositif est verrouillé, les signaux d'entrée du comparateur de phase 2 sont en phase, la tension sur le filtre 3 ne varie pas et la fréquence de sortie du VCO est constante. Cette fréquence est égale à N fois la fréquence de la synchronisation.

En cas de saut de phase du signal de synchronisation issu de l'extracteur 1 (signal de référence), ledit signal de synchronisation et le signal rebouclé ne sont plus en phase. Le comparateur fait alors varier la tension sur le filtre 3 et par conséquent la tension en entrée du VCO 4. La fréquence de sortie de ce dernier varie alors de manière à remettre en phase les deux signaux d'entrée du comparateur de phase 2.

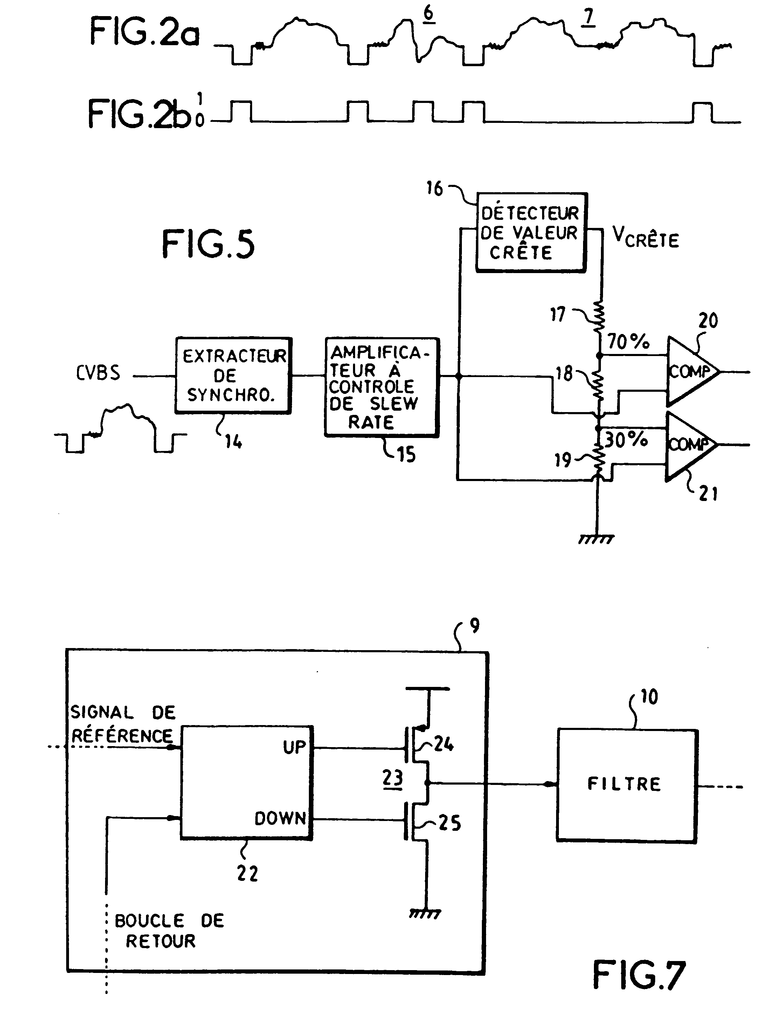

La figure 2a montre un exemple de signal CVBS, ainsi que deux défauts 6 et 7 pouvant conduire à l'obtention d'impulsions de synchronisation erronées. Un tel signal CVBS bruité se rencontre dans la pratique, par exemple à la sortie d'un magnétoscope.

La figure 2b représente le signal élaboré par l'extracteur de synchronisation 1 à partir du signal CVBS représenté par la figure 2a. Le défaut 6 crée une impulsion parasite 6a, tandis que le défaut 7 cause une absence d'impulsion. Dans les deux cas, il y a déverrouillage de la boucle PLL.

La fréquence de sortie de la boucle PLL est donc sujette à des variations. Celles-ci peuvent être gênantes notamment dans les trois cas suivants :
- Lorsque le gain du VCO 4 est important, les variations de la fréquence de sortie sont grandes même pour de faibles variations de tension à l'entrée dudit VCO.
- Lorsque le comparateur de phase 3 comporte un détecteur phase-fréquence ("Phase-Frequency Detector" ou PFD) possédant des sorties logiques comme décrit ci-après, un faible saut de phase en entrée peut le faire basculer. Il n'y a pas de gradation entre l'état haut et l'état bas des sorties PFD. De même que pour un gain élevé du VCO 4, ceci peut causer de rapides variations ("jitter") de la fréquence de sortie.
- Lorsque la fréquence de sortie pilote des circuits digitaux, même de faibles variations de ladite fréquence peuvent occasionner un mauvais fonctionnement.

De tels défauts se rencontrent notamment dans les circuits intégrés, par exemple du type CMOS.

L'invention a pour but d'éviter le déverrouillage d'une boucle à verrouillage de phase dû à un signal CVBS de qualité médiocre. En conséquence, un but de l'invention est d'améliorer l'immunité au bruit d'une boucle à verrouillage de phase et de minimiser les variations rapides ou "jitter" de la fréquence de sortie de la boucle à verrouillage de phase.

L'invention a pour objet un procédé d'amélioration de l'immunité au bruit d'une boucle à verrouillage de phase, ladite boucle à verrouillage de phase comprenant un comparateur et des moyens d'inhibition de l'action du comparateur sur ladite boucle à verrouillage de phase, ledit procédé étant caractérisé en ce que ladite inhibition est levée au cours d'une fenêtre temporelle principale résultant de l'intersection d'une première fenêtre temporelle élaborée à partir du signal d'entrée de la boucle à verrouillage de phase et d'une seconde fenêtre temporelle élaborée à partir du signal de retour de boucle.

Dans ce qui suit, le terme "signal de référence" se réfère au signal sur la fréquence duquel on désire verrouiller la boucle PLL. Il s'agit donc du signal envoyé vers le comparateur de ladite boucle.

Le terme "signal d'entrée" se réfère au signal servant à élaborer ledit signal de référence.

Selon un mode de réalisation particulier, ledit signal de référence comprend des créneaux élaborés, par remise en forme, à partir d'impulsions extraites dudit signal d'entrée.

Selon un mode de réalisation particulier, ladite première fenêtre est déclenchée par une impulsion du signal d'entrée de la boucle à verrouillage de phase.

Selon un mode de réalisation particulier, la première fenêtre a pour but d'autoriser l'action du comparateur en présence d'une impulsion dans le signal d'entrée.

Selon un mode de réalisation particulier, le comparateur reçoit un signal de référence comprenant des créneaux élaborés à partir d'impulsions extraites du signal d'entrée.

Selon un mode de réalisation particulier, ladite fenêtre est matérialisée par des créneaux élaborés à partir d'impulsions du signal d'entrée, les créneaux de la fenêtre analogique recouvrant temporellement le front actif des créneaux correspondants du signal de référence envoyé au comparateur.

Selon un mode de réalisation particulier, le signal correspondant à la première fenêtre comporte un créneau lorsqu'une impulsion du signal d'entrée dépasse un premier seuil de tension.

Selon un mode de réalisation particulier, le signal de référence comporte un créneau lorsqu'une impulsion du signal d'entrée dépasse un second seuil de tension situé entre le premier seuil de tension et la tension crête de l'impulsion

Selon un mode de réalisation particulier, ladite seconde fenêtre n'autorise l'action du comparateur qu'autour du front actif du signal de retour de boucle.

Selon un mode de réalisation particulier, la boucle de verrouillage de phase comprend un diviseur de fréquence dans sa boucle de retour, ledit diviseur comprenant un compteur à N états comptant les impulsions de sortie de la boucle à verrouillage de phase, ledit diviseur générant le signal de retour de boucle transmis au comparateur.

Selon un mode de réalisation particulier, ladite seconde fenêtre n'autorise l'action du comparateur que pendant les x états précédants et les y états suivant la transition du diviseur qui définit le front actif du signal de retour de boucle.

Selon un mode de réalisation particulier, l'action inhibitrice du signal correspondant à la seconde fenêtre n'est mise en oeuvre que lorsque la boucle à verrouillage de phase est verrouillée.

Selon un mode de réalisation particulier, l'état de verrouillage est défini par une variable booléenne (MUTE), mise à l'état vrai lorsque pour n impulsions successives extraites du signal d'entrée, les fronts actifs correspondants du signal de référence se trouvent à l'intérieur de la seconde fenêtre.

Selon un mode de réalisation particulier, ladite variable boléenne (MUTE) est mise à l'état faux lorsque pour n impulsions successives extraites du signal d'entrée, les fronts actifs correspondants du signal de référence se trouvent à l'intérieur de la seconde fenêtre.

Selon un mode de réalisation particulier, le signal correspondant à la fenêtre temporelle principale résulte d'un "ET" logique entre le signal correspondant à la première fenêtre et le signal correspondant à la seconde fenêtre.

L'invention aussi pour objet un dispositif comportant une boucle- de verrouillage de phase et mettant en oeuvre le procédé conforme à l'invention, caractérisé en ce que ledit dispositif comprend des moyens de création de la fenêtre temporelle principale pendant laquelle le comparateur peut agir sur la fréquence de sortie de ladite boucle à verrouillage de phase, ledit comparateur étant un comparateur de phase et/ou fréquences dont les sorties contrôlent les transistors d'un circuit pompe de charges chargeant un filtre de boucle, les sorties du comparateur étant inactivées en dehors de ladite fenêtre temporelle.

Selon un mode de réalisation particulier du dispositif conforme à l'invention, les moyens d'élaboration de la fenêtre temporelle principale comprennent des moyens d'élaboration d'une première fenêtre temporelle comportant un amplificateur à contrôle de slew-rate, dont la sortie est connectée à un détecteur de crête alimentant un pont de résistances dont une connexion fournit le pourcentage désiré de ladite valeur crête à l'entrée négative d'un comparateur, l'entrée positive dudit comparateur étant connecté à la sortie d'un amplificateur, la sortie dudit comparateur fournissant le signal représentant ladite première fenêtre.

D'autres avantages et caractéristiques de l'invention apparaîtront à travers la description d'un mode de réalisation préférentiel non limitatif illustré par les figures jointes, parmi lesquelles:
- La figure 1, déjà décrite, représente un diagramme fonctionnel d'une boucle à verrouillage de phase de type connu.
- La figure 2, déjà décrite, représente deux signaux présents dans une boucle à verrouillage de phase connue:
- la figure 2a représentant un signal d'entrée CVBS,
- la figure 2b représentant les signaux de synchronisation après extraction servant de signaux de référence,
- La figure 3 représente un diagramme fonctionnel d'une boucle à verrouillage de phase mettant en oeuvre le procédé conforme à l'invention,
- La figure 4 illustre le principe de génération de la fenêtre analogique à partir des impulsions de synchronisation extraites du signal d'entrée,
- la figure 4a représentant une impulsion de synchronisation extraite du signal d'entrée,
- la figure 4b représentant la fenêtre analogique correspondante, et
- la figure 4c le créneau correspondant du signal de référence envoyé vers le comparateur.
- La figure 5 représente un diagramme fonctionnel d'un circuit d'élaboration de la fenêtre analogique et du signal de référence à partir des impulsions de synchronisation extraites du signal d'entrée.
- La figure 6 représente schématiquement différents signaux présents dans une boucle à verrouillage de phase munie d'un dispositif conforme à l'invention,
- la figure 6a représentant un signal d'entrée CVBS,
- la figure 6b représentant le signal de référence envoyé vers le comparateur,
- la figure 6c représentant les fenêtres analogiques associées,
- la figure 6d représentant les fenêtres digitales associées,
- la figure 6e représentant les fenêtres temporelles de comparaison qui résultent des fenêtres analogiques et digitales.
- La figure 7 représente un comparateur suivant le mode de réalisation particulier de l'invention
- la figure 8 représente le principe d'élaboration de la fenêtre digitale.

Selon le mode particulier de réalisation décrit ci-dessous, le signal d'entrée est un signal vidéo composite bande de base, dont un circuit d'extraction extrait les impulsions de synchronisation sur la fréquence desquelles on désire verrouiller la boucle à verrouillage de phase.

Dans ce qui suit, les signaux correspondant aux différentes fenêtres temporelles, ainsi que le signal de référence sont des signaux logiques, tandis que le signal d'entrée (le signal CVBS) et la synchronisation extraite sont des signaux analogiques.

Une boucle à verrouillage de phase mettant en oeuvre le procédé d'amélioration de l'immunité au bruit conforme à l'invention comporte un circuit 8 ayant pour fonction, d'une part l'extraction des signaux de synchronisation à partir du signal d'entrée, d'autre part l'élaboration de fenêtres analogiques et d'un signal de référence destiné au comparateur de la boucle PLL, cette élaboration étant faite à partir des impulsions de synchronisation extraites. Le circuit 8 reçoit en entrée le signal de référence CVBS. La boucle munie du dispositif selon l'invention comporte en outre un comparateur de phase 9 fournissant une tension en relation avec la différence de phase et/ou de fréquence des deux signaux à son entrée.

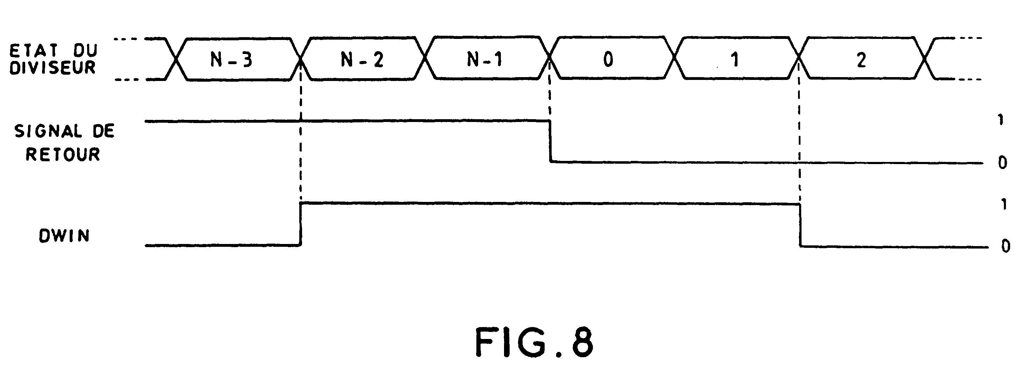

Avantageusement, le comparateur de phase 9, représenté à la figure 7, comporte un détecteur fréquence-phase 22 suivi d'une pompe de charges ("charge pump") 23. Le comparateur 9 est suivi par un filtre 10 et un VCO 11, la sortie de ce dernier rebouclant sur l'entrée du comparateur par un diviseur par N de référence 12.

Le détecteur phase-fréquence "(PFD)" 22 possède, par rapport à un détecteur de phase "(PD)" une mémoire lui permettant de comparer aussi bien la fréquence que la phase. Ceci empêche un verrouillage sur les harmoniques de la fréquence à verrouiller. Néanmoins, selon l'application, un détecteur de phase simple, ou d'ailleurs un comparateur d'un autre type, peut aussi être utilisé.

Le PFD 22 possède deux sorties logiques, "UP" et "DOWN", dont l'état, haut ou bas, dépend du résultat de la comparaison entre les fronts montants des signaux de référence et de retour de boucle. Ces deux sorties ne peuvent être toutes les deux actives en même temps. Les sorties alimentent une pompe à charges 23, dont le but est de convertir les états logiques des sorties du PFD 22 en signaux analogiques adaptés au contrôle du VCO 11.

Les sorties "UP" et "DOWN" du PFD 22 sont connectées respectivement à la grille des transistors 24 ou 25 de la pompe de charges 23, le transistor 24 servant à charger le filtre 10, le transistor 25 à le décharger. Lorsque la sortie UP est à l'état haut et la sortie DOWN à l'état bas, la pompe de charges est à l'état haute impédance. D'éventuels inverseurs nécéssaires à la commande des transistors 24 et 25 ne sont pas représentés.

L'utilisation de détecteurs PFD dans les boucles à verrouillage de phase est décrite par exemple dans les documents "Charge-Pump Phase-Lock Loops" in IEEE Transactions on Communications, Vol. Com-28, N° 11, November 1980 et "Design of PLL based clock generation circuits", IEEE Journal of Solid State circuits, Vol. SC 22, N°2, April 1987.

Le filtre 10 et le VCO 11 sont en soi bien connus de l'homme de l'art et ne seront pas décrits de façon plus détaillée.

La fréquence de sortie FS de la boucle à verrouillage de phase est disponible en soi, par exemple pour servir d'horloge à un circuit digital.

Le fonctionnement d'une boucle à verrouillage de phase est en soi connu. Cependant, en conformité avec l'invention, le comparateur 9 n'agit sur la fréquence de sortie FS que pendant un laps de temps défini par une fenêtre temporelle. En dehors de cette fenêtre, le comparateur ne fait pas varier la tension sur le filtre 10.

Selon le mode de réalisation préférentiel de l'invention, cette fenêtre temporelle résulte de l'intersection de deux types de fenêtres, fenêtre analogique et fenêtre digitale.

La fenêtre analogique est créée par le circuit 8. Elle a pour fonction de n'autoriser la comparaison de phase/fréquence par le comparateur 9 que si le signal d'entrée comporte effectivement une impulsion de synchronisation.

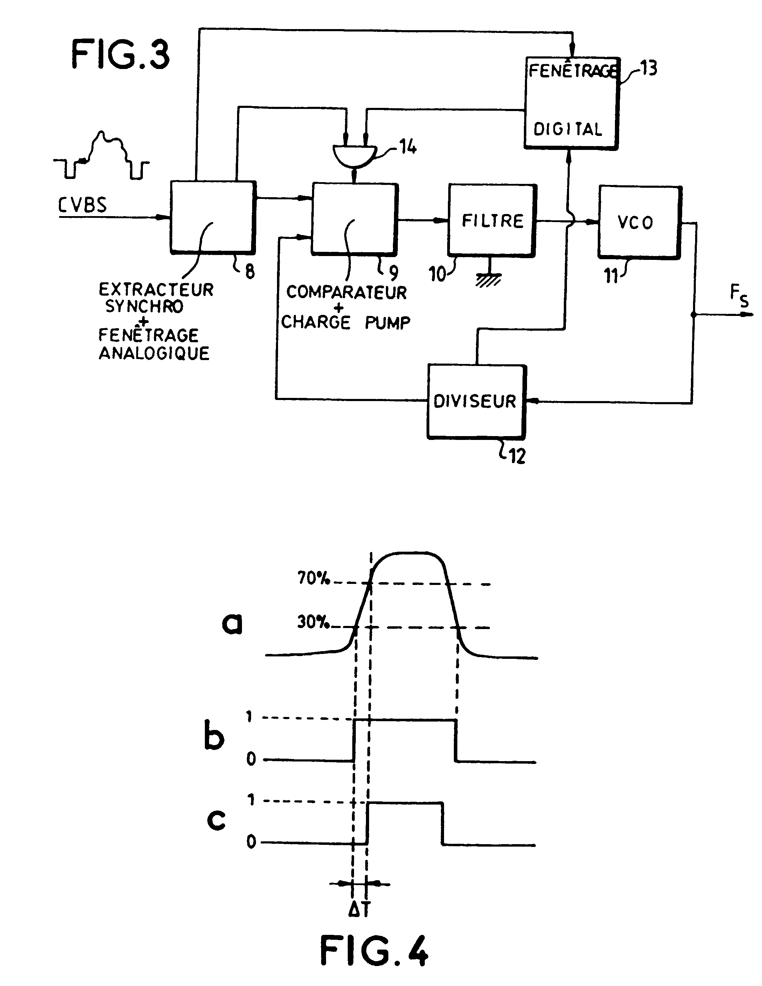

Le circuit 8 comprend un extracteur de synchronisation, élaborant un signal tel que le signal de la figure 2b. A partir de ce signal, dont une impulsion est représentée à la figure 4a, le circuit 8 crée la fenêtre analogique représentée à la figure 4b et le créneau correspondant du signal de référence représenté à la figure 4c, ce dernier étant envoyé vers le comparateur 9.

La fenêtre analogique existe lorsque l'impulsion de synchronisation extraite du signal d'entrée dépasse les 30% de sa valeur maximale.

Le créneau du signal de référence envoyé vers le comparateur existe lorsque l'impulsion de synchronisation extraite du signal de référence dépasse 70% de sa valeur maximale.

Du fait de la pente de l'impulsion extraite, le front montant de la fenêtre analogique est en avance de ΔT sur le front montant du créneau envoyé vers le comparateur 9.

Le temps ΔT généré doit permettre à la boucle à verrouillage de phase de se verrouiller suffisamment rapidement dans le cas où elle n'est pas dans un état stable, ce qui peut être le cas par exemple lors d'un changement de canal de télévision.

Pour cela, on pourrait jouer sur la valeur des seuils, les valeurs de 30% et 70% n'étant données qu'à titre d'exemple. Ces seuils peuvent aussi être plus rapprochés.

Selon un mode de réalisation, on joue également sur la pente des impulsions de synchronisation extraites du signal d'entrée, en faisant passer celles-ci à travers un amplificateur dont le "slew-rate" est judicieusement choisi (effet de filtrage). Le retard ΔT peut également être généré par d'autres moyens, comprenant par exemple des éléments à retard.

La figure 5 représente schématiquement un circuit d'élaboration de la fenêtre analogique et des impulsions envoyées vers le comparateur 9.

Un extracteur de synchronisation 14 reçoit en entrée le signal CVBS clampé et fournit un signal de synchronisation extrait (et inversé) à un amplificateur à contrôle de "slew-rate" 15.

L'amplificateur 15 permet de contrôler la pente des impulsions du signal de synchronisation extrait pour l'obtention d'un ΔT acceptable.

La valeur crête de ce signal est mémorisée par un détecteur de valeur crête 16, qui en sortie fournit ladite valeur crête à un pont de résistances (17,18,19), dont les valeurs sont choisies de façon à fournir les tensions seuil nécessaires (30% et 70% de la valeur de la tension crête dans l'exemple choisi).

Il est à noter que la valeur crête mémorisée correspond à la valeur d'une impulsion antérieure. On suppose que cette valeur ne varie pas dans de grandes proportions entre deux impulsions consécutives.

Les tensions seuil sont envoyées sur les entrées négatives de deux comparateurs (comparateur 20 pour la tension à 70% et comparateur 21 pour la tension à 30% de la tension crête).

L'entrée positive de chaque comparateur est connectée à la sortie de l'amplificateur 15.

La sortie du comparateur 20 correspond donc aux impulsions de synchronisation remises en forme pour être envoyées au comparateur phase/fréquence 9: il s'agit du signal de référence de la boucle à verrouillage de phase. La sortie du comparateur 21 fournit le signal correspondant à la fenêtre analogique.

La fenêtre digitale est élaborée par un circuit 13 recevant en entrée, l'état du diviseur 12 ainsi que les impulsions de synchronisation extraites. Elle n'est mise en oeuvre que lorsque la boucle est verrouillée de façon suffisante.

Selon le présent exemple, le diviseur 12 comporte un compteur de 0 à N-1 qui comptabilise les coups d'horloge issus du VCO 11. Le signal de retour du diviseur 12 (signal envoyé vers le comparateur) comporte un front actif à chaque passage de l'état N-1 à l'état 0 du compteur. Ce principe est schématiquement illustré à la figure 8, où le front actif est un front descendant.

Le circuit 13 reçoit l'état du compteur. Il élabore un signal de fenêtre (DWIN) qui entoure ledit front actif du signal de retour. Dans l'exemple de la figure 8, la largeur de la fenêtre DWIN est de ± deux coups d'horloge autour du front actif. Le signal DWIN est à 1 pour les états N-2, N-1, 0 et 1 du compteur du diviseur 12.

Le circuit 13 comporte pour ce faire des comparateurs adéquats dont les sorties sont reliées à l'entrée d'un OU logique. La sortie de cet OU donne le signal correspondant à la fenêtre digitale. D'autres réalisations sont bien évidemment envisageables.

Comme il a été précisé précédemment, la mise en action effective de la fenêtre digitale sur le contrôle de la boucle à verrouillage de phase n'a lieu que lorsque cette boucle est verrouillée.

Selon un exemple de réalisation particulier, pour contrôler la mise en action de la fenêtre digitale, le circuit 13 change l'état d'un bit de contrôle. Ce bit, dit MUTE sera mis à l'état haut si pour n impulsions de synchronisation extraites successives, les fronts actifs de ces impulsions existent pendant le fenêtre DWIN. C'est à ce moment qu'on dira que la boucle est verrouillée. MUTE sera mis à l'état bas si pour n impulsions de synchronisation, les fronts actifs de ces synchronisations existent en dehors de la fenêtre DWIN : la boucle sera alors dite non verrouillée.

Le signal envoyé vers le "et" logique 14 à partir du circuit 13 résulte d'un "et" logique entre le signal DWIN et l'état du bit MUTE. L'état du bit MUTE définit donc un cycle d'hystérésis. Pour un état donné de ce bit, il faudra au moins n impulsions successives soit à l'intérieur de la fenêtre DWIN, soit à l'extérieur suivant l'état de MUTE pour changer ledit état.

Cet hystérésis présente deux avantages, le premier étant de permettre un verrouillage sans gêne occasionnée par la fenêtre digitale, le second étant le maintien de la fenêtre digitale lorsque la synchronisation présente un léger jitter.

Selon un exemple de réalisation particulier, n = 10.

De même que la fenêtre analogique, la fenêtre digitale englobe le front actif du créneau correspondant du signal de référence envoyé au comparateur 9.

Les signaux élaborés par le circuit de fenêtrage digital 13 et la partie du circuit 8 concernant le fenêtrage analogique sont envoyés aux deux entrées d'un "et" logique, dont la sortie est connectée au circuit comparateur 9.

La figure 6 donne un exemple schématique des différents signaux présents dans le dispositif conforme à l'invention. Sur le schéma, le front actif des impulsions de synchronisation est le front avant, mais il est bien entendu possible d'utiliser le front arrière.

Le signal d'entrée bruité CVBS est similaire à celui de la figure 2a.

Le signal de la figure 6b est le signal de référence disponible à la sortie du circuit 8. Comme précédemment, le défaut 6 provoque l'apparition d'une impulsion supplémentaire dans le signal de la figure 6b, tandis que le défaut 7 provoque une absence d'impulsion.

Le signal représenté à la figure 6c correspond au signal de fenêtre analogique fourni par le circuit 8 au "et" logique" 14. On notera que ce signal présente sur son front montant une légère avance ΔT sur le front montant des impulsions envoyées vers le comparateur 9 (figure 6b).

La figure 6d montre le signal de fenêtre digitale envoyé par le circuit 13 au "et" logique 14, tandis que la figure 6e montre le signal à la sortie du circuit "et" logique 14 : il s'agit du signal de fenêtre temporelle.

On notera que les impulsions de ce dernier signal "encadrent" les fronts montants des créneaux du signal de référence envoyé au comparateur 9.

La comparaison par le comparateur 9 n'est autorisée qu'en présence d'un 1 logique à la sortie du circuit 14. Ce n'est qu'à ce moment là que la pompe de charges peut fonctionner. Dans le cas contraire, c'est à dire lorsque le signal de fenêtre temporelle est au 0 logique, la sortie du détecteur phase-fréquence est mise en haute impédance.

La fenêtre analogique permet l'élimination des effets du défaut 7 en ne permettant une comparaison par le comparateur 9 que lorsqu'une impulsion est effectivement présente dans le signal d'entrée, tandis que la fenêtre digitale permet l'élimination des effets du défaut 6, en interdisant une comparaison à des moments où une impulsion ne devrait pas exister. La combinaison des deux fenêtres permet l'annulation des défauts qu'introduirait la fenêtre digitale si elle était utilisée seule: Lorsqu'un créneau est présent dans le signal de fenêtre digitale alors qu'aucune impulsion de synchronisation n'existe dans le signal d'entrée, le signal de fenêtre analogique est au zéro logique et la comparaison n'est pas autorisée.

Selon un mode de réalisation particulier, seule l'une des fenêtres analogique ou digitale est utilisée pour l'élaboration de la fenêtre temporelle.

Il est bien évident que la présente invention peut être appliquée à des boucles à verrouillage de phase dont la structure diffère de celle décrite dans le mode particulier de réalisation.

Selon l'exemple de réalisation présenté, la fenêtre digitale est définie par les deux états suivant et précédant le passage à zéro du compteur du diviseur. On peut bien entendu envisager une définition par d'autres états, notamment plus de quatre.

## Revendications

1. Procédé d'amélioration de l'immunité au bruit d'une boucle à verrouillage de phase, ladite boucle à verrouillage de phase comprenant un comparateur (9) et des moyens d'inhibition (14) de l'action du comparateur sur ladite boucle à verrouillage de phase, ledit procédé étant caractérisé en ce que ladite inhibition est levée au cours d'une fenêtre temporelle principale résultant de l'intersection d'une première fenêtre temporelle élaborée à partir du signal d'entrée de la boucle à verrouillage de phase et d'une seconde fenêtre temporelle élaborée à partir du signal de retour de boucle.

2. Procédé selon la revendication 1, caractérisé en ce que ladite première fenêtre est déclenchée par une impulsion du signal d'entrée de la boucle à verrouillage de phase.

3. Procédé selon l'une des revendications précédentes, caractérisé en ce que la première fenêtre a pour but d'autoriser l'action du comparateur (9) en présence d'une impulsion dans le signal d'entrée.

4. Procédé selon l'une des revendications précédentes, caractérisé en ce que le comparateur (9) reçoit un signal de référence comprenant des créneaux élaborés à partir d'impulsions extraites du signal d'entrée.

5. Procédé selon la revendications 4, caractérisé en ce que ladite fenêtre est matérialisée par des créneaux élaborés à partir d'impulsions du signal d'entrée, les créneaux de la fenêtre analogique recouvrant temporellement le front actif des créneaux correspondants du signal de référence envoyé au comparateur (9).

6. Procédé selon l'une des revendications 4 ou 5, caractérisé en ce que le signal correspondant à la première fenêtre comporte un créneau lorsqu'une impulsion du signal d'entrée dépasse un premier seuil de tension.

7. Procédé selon la revendication 6, caractérisé en ce que le signal de référence comporte un créneau lorsqu'une impulsion du signal d'entrée dépasse un second seuil de tension situé entre le premier seuil de tension et la tension crête de l'impulsion

8. Procédé selon l'une des revendications précédentes, caractérisé en ce que ladite seconde fenêtre n'autorise l'action du comparateur qu'autour du front actif du signal de retour de boucle.

9. Procédé selon l'une des revendications précédentes, caractérisé en ce que la boucle de verrouillage de phase comprend un diviseur de fréquence dans sa boucle de retour, ledit diviseur comprenant un compteur à N états comptant les impulsions de sortie de la boucle à verrouillage de phase, ledit diviseur générant le signal de retour de boucle transmis au comparateur (9).

10. Procédé selon la revendication 9, caractérisé en ce que ladite seconde fenêtre n'autorise l'action du comparateur que pendant les x états précédant et les y états suivant la transition du diviseur qui définit le front actif du signal de retour de boucle.

11. Procédé selon l'une des revendications précédentes, caractérisé en ce que l'action inhibitrice du signal correspondant à la seconde fenêtre n'est mise en oeuvre que lorsque la boucle à verrouillage de phase est verrouillée.

12. Procédé selon la revendication 11, caractérisé en ce que l'état de verrouillage est défini par une variable booléenne (MUTE), mise à l'état vrai lorsque pour n impulsions successives extraites du signal d'entrée, les fronts actifs correspondants du signal de référence se trouvent à l'intérieur de la seconde fenêtre.

13. Procédé selon la revendication 12, caractérisé en ce que ladite variable boléenne (MUTE) est mise à l'état faux lorsque n impulsions successives extraites du signal d'entrée, les fronts actifs correspondants du signal de référence se trouvent à l'intérieur de la seconde fenêtre.

14. Procédé selon l'une des revendications précédentes, caractérisé en ce que le signal correspondant à la fenêtre temporelle principale résulte d'un "ET" logique entre le signal correspondant à la première fenêtre et le signal correspondant à la seconde fenêtre.

15. Dispositif comportant une boucle à verrouillage de phase comprenant un comparateur (9) et mettant en oeuvre le procédé selon l'une des revendications précédentes, caractérisé en ce que ledit dispositif comprend des moyens de création (8,13,14) de la fenêtre temporelle principale pendant laquelle le comparateur (9) peut agir sur la fréquence de sortie (Fs) de ladite boucle à verrouillage de phase, ledit comparateur étant un comparateur de phase et/ou fréquences (22) dont les sorties (UP,DOWN) contrôlent les transistors (24,25) d'un circuit pompe de charges (23) chargeant un filtre de boucle (10), les sorties du comparateur étant inactivées en dehors de ladite fenêtre temporelle.

16. Dispositif selon la revendication précédente, caractérisé en ce que les moyens d'élaboration de la fenêtre temporelle principale comprennent des moyens d'élaboration d'une première fenêtre temporelle comportant un amplificateur à contrôle de slew-rate (15), dont la sortie est connectée à un détecteur de crête (16) alimentant un pont de résistances (17,18,19) dont une connexion fournit le pourcentage désiré de ladite valeur crête à l'entrée négative d'un comparateur (21), l'entrée positive dudit comparateur (21) étant connecté à la sortie d'un amplificateur (15), la sortie dudit comparateur fournissant le signal représentant ladite première fenêtre.

## Patentansprüche

1. Verfahren zur Verbesserung der Rauschunempfindlichkeit einer Phasenregelschleife, die einen Vergleicher (9) und Mittel zum Sperren (14) der Wirkung des Vergleichers auf die besagte Phasenregelschleife umfaßt, wobei das besagte Verfahren dadurch gekennzeichnet ist, daß die besagte Sperrung im Verlauf eines Hauptzeitfensters, das sich aus der Überschneidung eines aus dem Eingangssignal der Phasenregelschleife gewonnenen ersten Zeitfensters und eines aus dem Schleifenrückkopplungssignal gewonnenen zweiten Zeitfensters ergibt, aufgehoben wird.

2. Verfahren nach Anspruch 1, dadurch gekennzeichnet, daß das besagte erste Fenster durch einen Impuls des Eingangssignals der Phasenregelschleife ausgelöst wird.

3. Verfahren nach einem der vorhergehenden Ansprüche, dadurch gekennzeichnet, daß das erste Fenster die Aufgabe hat, das Wirksamwerden des Vergleichers (9) in der Gegenwart eines Impulses im Eingangssignal zu gestatten.

4. Verfahren nach einem der vorhergehenden Ansprüche, dadurch gekennzeichnet, daß der Vergleicher (9) ein Bezugssignal mit Schlitzen empfängt, die aus vom Eingangssignal gewonnenen Impulsen erzeugt werden.

5. Verfahren nach Anspruch 4, dadurch gekennzeichnet, daß das besagte Fenster aus Schlitzen besteht, die aus Impulsen des Eingangssignals gewonnen werden, wobei die Schlitze des analogen Fensters zeitweilig die aktive Flanke von entsprechenden Schlitzen des zum Vergleicher (9) gesandten Bezugssignals überdecken.

6. Verfahren nach Anspruch 4 oder 5, dadurch gekennzeichnet, daß das dem ersten Fenster entsprechende Signal einen Schlitz umfaßt, wenn ein Impuls des Eingangssignals eine erste Spannungsschwelle überschreitet.

7. Verfahren nach Anspruch 6, dadurch gekennzeichnet, daß das Bemgssignal einen Schlitz umfaßt, wenn ein Impuls des Eingangssignals eine zweite Spannungsschwelle überschreitet, die sich zwischen der ersten Spannungsschwelle und der Spitzensspannung des Impulses befindet.

8. Verfahren nach einem der vorhergehenden Ansprüche, dadurch gekennzeichnet, daß das besagte zweite Fenster das Wirksamwerden des Vergleichers nur um die aktive Flanke des Schleifenrückkopplungssignals herum zuläßt.

9. Verfahren nach einem der vorhergehenden Ansprüche, dadurch gekennzeichnet, daß die Phasenregelschleife einen Frequenzteiler in ihrer Rückkopplungsschleife umfaßt, wobei der besagte Teiler einen Zähler mit N Zuständen umfaßt, der die Ausgangsimpulse der Phasenregelschleife zählt, wobei der besagte Teiler das zum Vergleicher (9) übertragene Schleifenrückkopplungssignal erzeugt.

10. Verfahren nach Anspruch 9, dadurch gekennzeichnet, daß das besagte zweite Fenster das Wirksamwerden des Vergleichers nur während der x Zustände vor und der y Zustande nach dem Übergang des Teilers, der die aktive Flanke des Schleifenrückkopplungssignals definiert, zuläßt.

11. Verfahren nach einem der vorhergehenden Ansprüche, dadurch gekennzeichnet, daß die Sperrwirkung des dem zweiten Fenster entsprechenden Signals nur dann veranlaßt wird, wenn die Phasenregelschleife eingerastet ist.

12. Verfahren nach Anspruch 11, dadurch gekennzeichnet, daß der Einrastzustand durch eine Boolesche Variable (MUTE) definiert wird, die in den Zustand wahr versetzt wird, wenn sich für aus dem Eingangssignal gewonnene aufeinanderfolgende n Impulse die entsprechenden aktiven Flanken des Bezugssignals innerhalb des zweiten Fensters befinden.

13. Verfahren nach Anspruch 12, dadurch gekennzeichnet, daß die besagte Boolesche Variable (MUTE) in den Zustand falsch versetzt wird, wenn sich für aus dem Eingangssignal gewonnene n aufeinanderfolgende Impulse die entsprechenden aktiven Flanken des Bezugssignals innerhalb des zweiten Fensters befinden.

14. Verfahren nach einem der vorhergehenden Ansprüche, dadurch gekennzeichnet, daß das dem Hauptzeitfenster entsprechende Signal sich aus einem logischen "UND" zwischen dem dem ersten Fenster entsprechenden Signal und dem dem zweiten Fenster entsprechenden Signal ergibt.

15. Vorrichtung mit einer Phasenregelschleife mit eine Vergleicher (9), die das Verfahren nach eine der vorhergehenden Ansprüche ausführt, dadurch gekennzeichnet, daß die besagte Vorrichtung Mittel zum Schaffen (8, 13, 14) des Hauptzeitfensters umfaßt, während dessen der Vergleicher (9) auf die Ausgangsfrequenz (Fs) der besagten Phasenregelschleife einwirken kann, wobei der besagte Vergleicher ein Phasen- und/oder Frequenz-Vergleicher (22) ist, dessen Ausgänge (UP, DOWN) die Transistoren (24, 25) einer Ladungspumpschaltung (23) steuern, die ein Schleifenfilter (10) beladet, wobei die Ausgänge des Vergleichers außerhalb des besagten Zeitfensters deaktiviert sind.

16. Vorrichtung nach dem vorhergehenden Anspruch, dadurch gekennzeichnet, daß die Mittel zum Gewinnen des Hauptzeitfensters Mittel zum Gewinnen eines ersten Zeitfensters mit einem Slew-rate-Steuerverstärker (15) umfassen, dessen Ausgang mit einem Spitzenwertdetektor (16) verbunden ist, der eine Widerstandsbrücke (17, 18, 19) speist, bei der eine Verbindung den gewünschten Prozentsatz des besagten Spitzenwertes zum negativen Eingang eines Vergleichers (21) liefert, wobei der positive Eingang des besagten Vergleichers (21) mit dem Ausgang eines Verstärkers (15) verbunden ist, wobei der Ausgang des besagten Vergleichers das das besagte erste Fenster darstellende Signal liefert.

## Claims

1. Method of enhancing the noise immunity of a phase-locked loop, the said phase-locked loop comprising a comparator (9) and means (14) for inhibiting the action of the comparator on the said phase-locked loop, the said method being characterized in that the said inhibition is lifted in the course of a main time window resulting from the intersection of a first time window derived from the input signal of the phase-locked loop and of a second time window derived from the loop return signal.

2. Method according to Claim 1, characterized in that the said first window is triggered by a pulse of the input signal of the phase-locked loop.

3. Method according to one of the preceding claims, characterized in that the first window is for the purpose of enabling the action of the comparator (9) in the presence of a pulse in the input signal.

4. Method according to one of the preceding claims, characterized in that the comparator (9) receives a reference signal comprising strobes derived from pulses extracted from the input signal.

5. Method according to Claim 4, characterized in that the said window is physically represented by strobes derived from pulses of the input signal, the strobes of the analog window overlapping, in terms of time, the active edge of the corresponding strobes of the reference signal sent to the comparator (9).

6. Method according to one of Claims 4 and 5, characterized in that the signal corresponding to the first window includes a strobe when a pulse of the input signal exceeds and first voltage threshold.

7. Method according to Claim 6, characterized in that the reference signal includes a strobe when a pulse of the input signal exceeds a second voltage threshold situated between the first voltage threshold and the peak pulse voltage.

8. Method according to one of the preceding claims, characterized in that the said second window enables the action of the comparator only around the active edge of the loop return signal.

9. Method according to one of the preceding claims, characterized in that the phase-locked loop comprises a frequency divider in its return loop, the said divider comprising an N-state counter counting the output pulses of the phase-locked loop, the said divider generating the loop return signal sent to the comparator (9).

10. Method according to Claim 9, characterized in that the said second window enables the action of the comparator only during the x states preceding and the y states following the transition of the divider which defines the active edge of the loop return signal.

11. Method according to one of the preceding claims, characterized in that the inhibiting action of the signal corresponding to the second window is implemented only when the phase-locked loop is locked.

12. Method according to Claim 11, characterized in that the locking state is defined by a boolean variable (MUTE), set to the true state when for n successive pulses extracted from the input signal, the corresponding active edges of the reference signal lie within the second window.

13. Method according to Claim 12, characterized in that the said boolean variable (MUTE) is set to the false state when, for n successive pulses extracted from the input signal, the corresponding active edges of the reference signal lie within the second window.

14. Method according to one of the preceding claims, characterized in that the signal corresponding to the main time window results from a logic "AND" between the signal corresponding to the first window and the signal corresponding to the second window.

15. Device including a phase-locked loop comprising a comparator (9) and implementing the method according to one of the preceding claims, characterized in that the said device comprises means (8, 13, 14) for creating the main time window during which the comparator (9) can act on the output frequency (Fs) of the said phase-locked loop, the said comparator being a phase and/or frequency comparator (22) the outputs of which (UP, DOWN) control the transistors (24, 25) of a charge-pump circuit (23) charging a loop filter (10), the outputs of the comparator being inactivated outside the said time window.

16. Device according to the preceding claim, characterized in that the means of deriving the main time window comprise means of deriving a first time window including a slew-rate-controlled amplifier (15), the output of which is connected to a peak detector (16) feeding a resistor bridge (17, 18, 19) one connection of which supplies the desired percentage of the said peak value to the negative input of a comparator (21), the positive input of the said comparator (21) being connected to the output of an amplifier (15), the output of the said comparator supplying the signal representing the said first window.
